# EUROPEAN PATENT APPLICATION

(11) **EP 3 203 542 A1**
(43) Date of publication of application: **09.08.2017**
(21) Application number: 15847102.9
(22) Date of filing: 30.09.2015
(51) Int. Cl.: H01L 51/42, H01L 51/44, H01L 51/48

(54) **ORGANIC SOLAR CELL MODULE AND METHOD FOR MANUFACTURING SAME**

(30) Priority: 30.09.2014 KR 20140131726
(71) Applicant: Kolon Industries, Inc., Gwacheon-si, Gyeonggi-do 13837 (KR)
(72) Inventor: KU, Ja Ram, Yongin-si Gyeonggi-do 446-797 (KR); CHO, Geun Sang, Yongin-si Gyeonggi-do 446-797 (KR); KIM, Kwang Su, Yongin-si Gyeonggi-do 446-797 (KR); CHOI, Yoon Young, Yongin-si Gyeonggi-do 446-797 (KR)
(74) Representative: Merkle, Gebhard
(86) International application number: PCT/KR2015/010270
(87) International publication number: WO 2016/052970

(57) **Abstract**

Disclosed is an organic solar cell module, which ensures the easy integrated formation of a wiring terminal, an electrode charging unit, or a USB charging unit, and a method of manufacturing the same. The organic solar cell module includes a terminal molding unit having a wiring terminal, which is integrally molded between a first electrode layer formed on one end ofae module main body and a second electrode layer formed on a remaining end of the module main body, the wiring terminal being connected to a power supply. A method of manufacturing the organic solar cell module includes forming a module main body, and forming a terminal molding unit having a wiring terminal, which is integrally molded between a first electrode layer formed on one end of the module main body and a second electrode layer formed on a remaining end of the module main body, the wiring terminal being connected to a power supply. With the organic solar cell module and the method of manufacturing the same, the wiring terminal for connection with the power supply may be easily formed, and easy charging of batteries of various electronic appliances as well as electronic appliances that are chargeable via an USB is possible by integrating a charging unit or a USB charging unit in the organic solar cell module. In addition, as a result of integrating the charging unit or the USB charging unit in the organic solar cell module, the number of processes of connecting the wiring terminal may be minimized, and increased durability and the easy charging of various electronic appliances may be accomplished.

## Description

### BACKGROUND OF THE INVENTION

### Field of the Invention

The present invention relates to an organic solar cell module and a method for manufacturing the same, and more particularly, to an organic solar cell module, which ensures the easy integrated formation of a wiring terminal, an electrode charging unit, or a USB charging unit, and a method for manufacturing the same.

### Description of the Related Art

In recent years, the consumption of fossil fuels is rapidly increasing throughout the world, and thus the price of oil is rapidly increasing, and the need for clean alternative energy is increasing due to environmental problems such as global warming. As a result, countries around the world are concentrating on renewable energy sources. In particular, the development of environmentally friendly pollution-free energy sources has recently been raised as a national challenge in response to the entry into force of the Kyoto Protocol.

Solar cell technology, which generates electricity from sunlight, which is an infinite source of energy, is the most interesting field among various renewable energy technologies. A solar cell is a device that converts light energy into electrical energy using a photovoltaic effect. Recently, with the rapid development of the information electronics industry, various flexible devices have been attracting attention as next-generation electric and electronic devices. An organic thin-film solar cell (hereinafter referred to as an "organic solar cell") satisfies the requirement for flexibility of such a device, and also has an advantage in that the material cost can be drastically reduced compared with an inorganic solar cell. In addition, due to the easy process-ability of organic matter, which is a constituent material of the organic solar cell, the organic solar cell has an advantage in that a large-area device may be manufactured at low cost through, for example, spin coating, screen printing, ink-jet printing, or fine contact printing.

Meanwhile, a solar cell includes a plurality of cells, each of which absorbs light and generates electric energy, arranged in a striped pattern to form a single unit, and a single unit of such cells is called a module. That is, in a general solar cell, one module may be used alone, and each module may constitute one solar cell. However, since the power generated by one module is very low, in most cases, a plurality of modules is interconnected to form a solar cell. A structure in which multiple modules are arranged is referred to as an array.

In order to connect such a solar cell to an auxiliary battery or a power supply of an application, it is necessary to appropriately adjust the voltage and current for each appliance before connection. The voltage and current of a solar cell module, which has a striped pattern, are determined depending on a semiconductor material, and are adjusted via the serial or parallel connection of solar cell modules. Accordingly, it is important to easily form electrode terminals in the array of the modules.

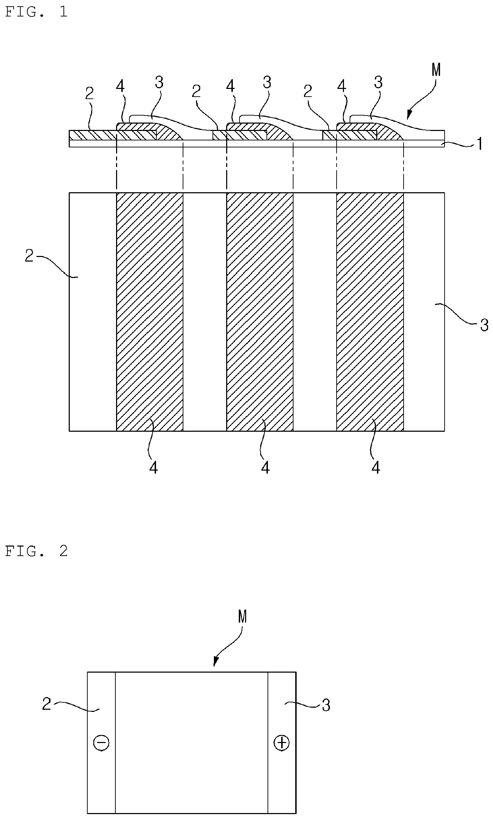

FIG. 1 illustrates, at the upper end thereof, a cross-sectional view illustrating the structure of a conventional organic solar cell module, and at the lower end thereof, a rear view corresponding thereto. As illustrated in FIG. 1, in one organic solar cell module M, a plurality of rows of a first electrode layer 2 is formed on a transparent substrate 1, and an optical active layer 4 is applied onto the first electrode layer 2. A second electrode layer 30 is formed on the optical active layer 4 prepared as described above. The second electrode layer 30 is a separate electrode that performs an electrode function opposite to the first electrode layer 2. At this time, the single module is provided on one end thereof with the first electrode layer 2 and on the other end thereof with the second electrode layer 3. Meanwhile, one row of the second electrode layer 3 is electrically connected to a neighboring row of the first electrode layer 2 with the optical active layer 4 interposed therebetween, whereby a plurality of cells formed in one module is electrically interconnected in series.

As disclosed in Korean Patent Registration No. 10-1364461 of the related art, a hole transport layer may be formed between the first electrode layer 2 and the optical active layer 4 and between the optical active layer 4 and the second electrode layer 3. A thin film may be formed by slightly moving the layers in order to successively connect opposite electrodes of the respective cells. A solar cell module, formed via the connection of unit elements (cells), may have a serial or parallel connection form. The reason why the module has this form is to attain a target voltage (in the case of serial connection) or a target current (in the case of parallel connection), and to minimize the loss (so-called "ohmic loss") caused when collecting holes and electrons because the sheet resistance of an electrode (e.g. an indium tin oxide (ITO) electrode) is large. It is most common to pattern the electrode in a striped form.

In the conventional organic solar cell module M configured as described above, as illustrated in FIG. 2, a first electrode terminal (negative pole) is disposed on the first electrode layer 2, which is formed on one end of the module, and a second electrode terminal (positive pole) is disposed on the second electrode layer 3, which is formed on the other end of the module. A plurality of first and second electrode terminals is interconnected in series or in parallel, and is used in a sealed structure that is capable of withstanding the natural environment and external shocks for a long time.

The conventional organic solar cell module M configured as described above, however, has problems in that a wire for connection with a power supply may be untidy because the electrode terminals are separately formed on opposite sides and that it is necessary to provide a separate charging unit in the solar cell module M or to use a charger, in order to charge a battery.

### SUMMARY OF THE INVENTION

Therefore, the present invention has been made in view of the above problems of the conventional organic solar cell module, and it is one object of the present invention to provide an organic solar cell module, which ensures the easy formation of a wiring terminal for connection with a power supply, and a method of manufacturing the same.

It is another object of the present invention to provide an organic solar cell module, which includes a charging unit to easily charge batteries of various electronic appliances, and a method of manufacturing the same.

It is a further object of the present invention to provide an organic solar cell module, which includes a USB charging unit to easily charge batteries of various electronic appliances that are chargeable via a USB, and a method of manufacturing the same.

In accordance with one aspect of the present invention, to accomplish the above and other objects, there is provided an organic solar cell module including a module main body having a plurality of rows of a first electrode layer and a plurality of rows of a second electrode layer formed on the first electrode layer with an optical active layer interposed therebetween, and a terminal molding unit having a wiring terminal, which is integrally molded between the first electrode layer formed on one end of the module main body and the second electrode layer formed on a remaining end of the module main body, the wiring terminal being connected to a power supply.

The terminal molding unit may include wires connected respectively to the first electrode layer and the second electrode layer, the wiring terminal integrally formed on an end of each wire so as to be connected to the power supply, and a molding portion integrally molded with the module main body so as to surround an end of the module main body, the wires, and a portion of the wiring terminal.

The module main body may include a plurality of unit modules arranged thereon, and the first electrode layer formed on the one end of the module main body and the second electrode layer formed on the remaining end of the module main body may be coated with a module connector, which electrically interconnects the unit modules so as to connect the unit modules to the wire.

The module connector may be formed as a silver (Ag) electrode via printing.

In accordance with another aspect of the present invention, there is provided an organic solar cell module including a module main body having a plurality of rows of a first electrode layer and a plurality of rows of a second electrode layer formed on the first electrode layer with an optical active layer interposed therebetween, an insulating portion formed between the first electrode layer formed on one end of the module main body and the second electrode layer formed on a remaining end of the module main body so as to insulate a conductive portion, an electrode connecting portion formed on the insulating portion to connect the first electrode layer and the second electrode layer to each other, and a wiring terminal formed on a middle portion of the electrode connecting portion and connected to a power supply.

The module main body may include a plurality of unit modules arranged thereon, and the first electrode layer formed on the one end of the module main body and the second electrode layer formed on the remaining end of the module main body may be coated with a module connector, which electrically interconnects the unit modules so as to connect the unit modules to the electrode connecting portion.

The wiring terminal may be a wiring terminal of a charging unit for connection with a power supply of a charger.

The wiring terminal may be a wiring terminal of a universal serial bus (USB) charging unit for connection with a USB.

The module connector or the electrode connecting portion may be formed as a silver (Ag) electrode via printing.

In accordance with another aspect of the present invention, there is provided a method of manufacturing an organic solar cell module, including forming a module main body having a plurality of rows of a first electrode layer and a plurality of rows of a second electrode layer formed on the first electrode layer with an optical active layer interposed therebetween, and forming a terminal molding unit having a wiring terminal, which is integrally molded between the first electrode layer formed on one end of the module main body and the second electrode layer formed on a remaining end of the module main body, the wiring terminal being connected to a power supply.

The forming the terminal molding unit may include connecting wires respectively to the first electrode layer and the second electrode layer and integrally forming the wiring terminal on an end of each wire, and integrally molding a molding portion with the module main body so as to surround an end of the module main body, the wires, and a portion of the wiring terminal.

In accordance with a further aspect of the present invention, there is provided a method of manufacturing an organic solar cell module, including forming a module main body having a plurality of rows of a first electrode layer and a plurality of rows of a second electrode layer formed on the first electrode layer with an optical active layer interposed therebetween, forming an insulating portion configured to insulate a conductive portion between the first electrode layer formed on one end of the module main body and the second electrode layer formed on a remaining end of the module main body, and forming respective electrode connecting portions on the insulating portion to connect the first electrode layer and the second electrode layer to each other and integrally forming a wiring terminal on an end of each electrode connecting portion.

### BRIEF DESCRIPTION OF THE DRAWINGS

The above and other objects, features and other advantages of the present invention will be more clearly understood from the following detailed description taken in conjunction with the accompanying drawings, in which:
FIG. 1 is a cross-sectional view illustrating the structure of a conventional organic solar cell module (at the upper end thereof) and a rear view corresponding thereto (at the lower end thereof);
FIG. 2 is a plan view schematically illustrating the arrangement of electrode terminals in the organic solar cell module of FIG. 1;
FIG. 3 is a plan view schematically illustrating an organic solar cell module according to a first embodiment of the present invention;
FIG. 4 is a cross-sectional view taken along the arrows A1-A1 of FIG. 3;
FIG. 5 is a cross-sectional view taken along the arrows B1-B1 of FIG. 3;
FIG. 6 is a flowchart illustrating a method of manufacturing the organic solar cell module according to the first embodiment of the present invention illustrated in FIG. 3;
FIG. 7 is a plan view schematically illustrating an organic solar cell module according to a second embodiment of the present invention;
FIG. 8 is a cross-sectional view taken along the arrows A2-A2 of FIG. 7;
FIG. 9 is a cross-sectional view taken along the arrows B2-B2 of FIG. 7; and
FIG. 10 is a flowchart illustrating a method of manufacturing the organic solar cell module according to the second embodiment of the present invention illustrated in FIG. 7.

### DETAILED DESCRIPTION OF THE INVENTION

Hereinafter, the exemplary embodiments of the present invention will be described in detail with reference to the accompanying drawings. Here, it is noted that, wherever possible, the same reference numbers will be used throughout the drawings to refer to the same or like parts. In addition, a detailed description of known functions and configurations incorporated herein will be omitted when it may make the subject matter of the present invention rather unclear. For the same reason, in the drawings, some constituent elements are exaggerated, omitted, or schematically illustrated.

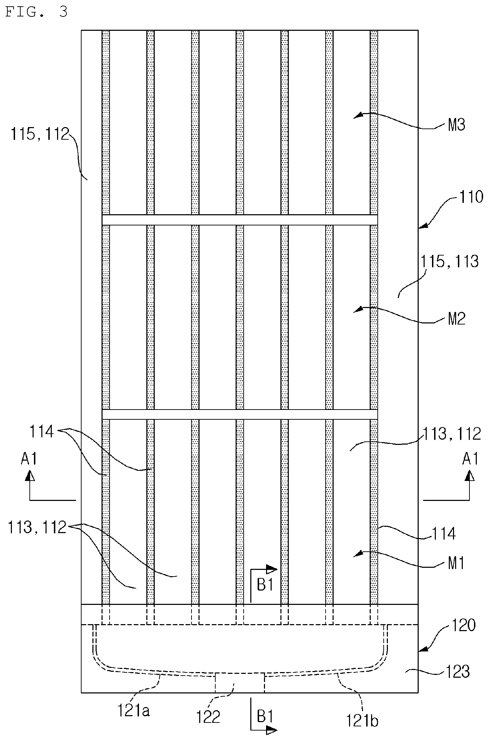

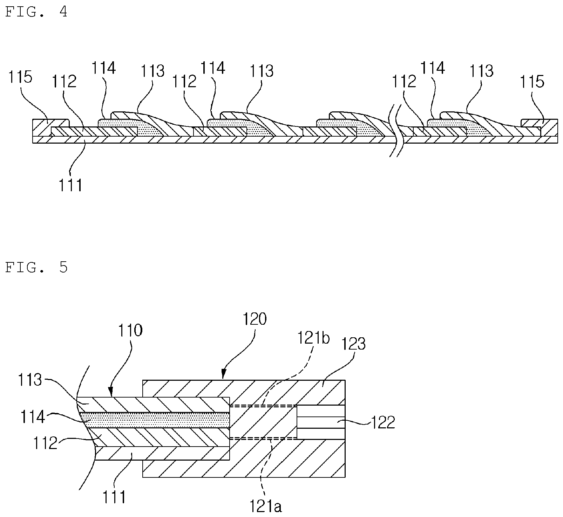

FIG. 3 is a plan view schematically illustrating an organic solar cell module according to a first embodiment of the present invention, FIG. 4 is a cross-sectional view taken along the arrows A1-A1 of FIG. 3, and FIG. 5 is a cross-sectional view taken along the arrows B1-B1 of FIG. 3. As illustrated, the organic solar cell module according to the first embodiment of the present invention includes a module main body 110 and a terminal molding unit 120. In the first embodiment, the module main body 110 has a structure in which three unit modules are integrally arranged on a single substrate 111.

Explaining one unit module, the module main body 110 is configured such that a plurality of rows of a first electrode layer 112 is formed on the substrate 111, an optical active layer 114 is applied onto the first electrode layer 112, and a second electrode layer 113, which is a separate electrode that performs an electrode function opposite to the first electrode layer 2, is formed on the optical active layer 114 prepared as described above. In the structure of the first embodiment, in which a plurality of unit modules M1, M2 and M3 is arranged, the first electrode layer 112 formed on one end and the second electrode layer 113 formed on the other end are coated with a module connector 115, which electrically interconnects the multiple unit modules so as to connect the unit modules to a wire. The module connector 115 is formed as a silver (Ag) electrode via printing using Ag paste.

One row of the second electrode layer 113 is electrically connected to a neighboring row of the first electrode layer 112, whereby a plurality of cells formed in one unit module is electrically interconnected in series. A solar cell requires a p-n junction in order to convert light energy into electrical energy. In the case of an organic solar cell, a donor and an acceptor are mixed to form a p-n junction, and a p-layer and an n-layer are not clearly distinguished from each other.

The substrate 111 may use an inorganic base film formed of, for example, quartz or glass, or may use a plastic base film formed of any one selected from among the group consisting of polyethylene terephthalate (PET), polyethylene naphthalate (PEN), polycarbonate (PC), polystyrene (PS), polypropylene (PP), polyimide (PI), polyethylene sulfonate (PES), polyoxymethylene (POM), polyether ether ketone (PEEK), polyether sulfone (PES), and polyetherimide (PEI), and the like. In particular, the plastic base film may be flexible and may also have high chemical stability, mechanical rigidity, and transparency.

The first electrode layer 112 may form an anode layer. The first electrode layer 112 may be formed of, for example, indium tin oxide (ITO), SnO₂, IZO (In₂O₃-ZnO), aluminum doped ZnO (AZO), gallium doped ZnO (GZO), graphene, CNT, nanowires, an Ag grid, or a conductive polymer (PEDOT:PSS), and may be coated with indium tin oxide (ITO).

The second electrode layer 113 may form a cathode layer. The second electrode layer 113 may be an Au, Ai, Ag, Ca, Mg, Ba, Mo, Al-Mg, or LiF-Al layer, and may be coated with Ag.

The optical active layer 114 may be any known one without limitation. In one example, the optical active layer 114 has a bulk hetero junction (BHJ) structure in which an electron acceptor and an electron donor are present in a mixed state. In addition, the optical active layer 114 may be of a bi-layer type. The electron donor may use any known material, such as, for example, a semiconductor polymer, a conjugated polymer, or a low molecular weight semiconductor, without limitation. For example, the electron donor may use a poly(para-phenylene vinylene)(PPV)-based material, a polythiophene derivative, or a phthalocyanine-based material. The electron acceptor may use any known material without limitation. For example, the electron acceptor may use any one of fullerene derivatives having high electron affinity, such as, for example, fullerene (e.g. C₆₀, C₇₀, C₇₆, C₇₈, C₈₂, C₉₀, C₉₄, C₉₆, C₇₂₀, or C₈₆₀) ; 1-(3-methoxy-carbonyl)propyl-1-phenyl(6,6)C61(1-(3-methoxycarbonyl) propyl-1-phenyl(6,6)C61: PCBM), C71-PCBM, C84-PCBM, bis-PCBM, or ThCBM.

A functional layer may be formed between the first electrode layer 112 and the optical active layer 114 and between the optical active layer 114 and the second electrode layer 113. The functional layer may be a hole transport layer or an electron transport layer. The hole transport layer may be formed of any known material without limitation. In one example, the hole transport layer may be formed using a material, such as MTDATA, TDATA, NPB, PEDOT:PSS, TPD, or a p-type metal oxide. The p-type metal oxide may be, for example, MoO₃ or V₂O₅. In addition, the hole transport layer may be a self-assembled thin film that is a metal layer. For example, a self-assembled thin film, which is formed via deposition and thermal treatment of Ni, may be used as the hole transport layer. The electron transport layer (ETP) serves to allow electrons generated in an optical active layer to be easily transported to an adjacent electrode. The electron transport layer may be formed of any known material without limitation. In one example, the electron transport layer may be formed using a material, such as aluminum tris(8-hydroxyquinoline) (Alq3), lithium fluoride (LiF), lithium complex (8-hydroxy-quinolinato lithium (Liq)), a non-conjugated polymer, a non-conjugated polymer electrolyte, a conjugated polymer electrolyte, or an n-type metal oxide. The n-type metal oxide may be, for example, TiOx, ZnO, or Cs₂CO₃. In addition, a self-assembled thin film that is a metal layer may be used as the electron transport layer.

The terminal molding unit 120 is integrally molded between the first electrode layer 112, which is formed on one end of the module main body 110, and the second electrode layer 113, which is formed on the other end of the module main body 110, and is connected to a power supply. The terminal molding unit 120 includes wires 121a and 121b connected respectively to the first electrode layer 112 and the second electrode layer 113, a wiring terminal 122 integrally formed on the end of each wire 121a or 121b so as to be connected to the power supply, and a molding portion 123 integrally molded on the module main body 110 so as to surround the end of the module main body 110, the wires 121a and 121b, and a portion of the wiring terminal 122.

The wiring terminal 122 may be a wiring terminal of a charging unit for connection with a power supply of a charger, or may be a wiring terminal of a universal serial bus (USB) charging unit for connection with a USB. Thus, the organic solar cell module of the present invention may be used to charge various electronic appliances because a USB connector is integrally connected to the electrode thereof, or may be used to charge various electronic appliances that are chargeable via a USB owing to a female-type USB charging unit formed therein.

The molding portion 123 may be formed of any material so long as it is insulative, and may be formed of various plastics or a mixed material of plastic and metal. The molding portion 123 may be formed of, for example, a transparent insulating material, such as polyethylene terephthalate (PET).

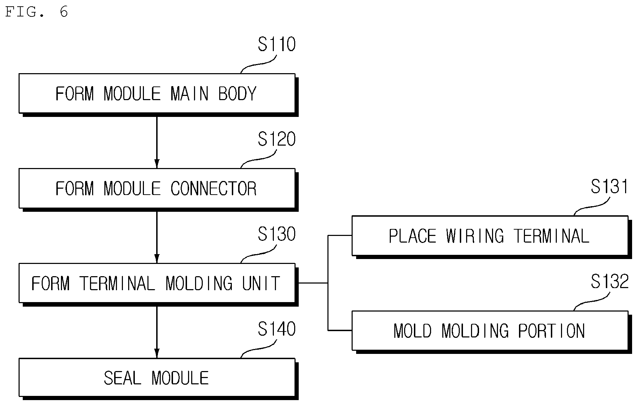

FIG. 6 is a flowchart illustrating a method of manufacturing the organic solar cell module according to the first embodiment of the present invention illustrated in FIG. 3. As illustrated, the method of manufacturing the organic solar cell module according to the first embodiment includes a step S110 of forming a module main body, a step S120 of forming a module connector, a step S130 of forming a terminal molding unit, and a step S140 of sealing the module.

The step S110 of forming the module main body 110 refers to the step of forming the first electrode layer 112, the optical active layer 114, and the second electrode layer 113 in multiple rows on the transparent substrate 111, which is transported by a roller. The step S120 of forming the module connector 115 refers to the step of coating the first electrode layer 112 formed on one end of a unit module and the second electrode layer 113 formed on the other end of the unit module with silver (Ag) paste, so as to electrically interconnect a plurality of unit modules.

The step S110 of forming the module main body 110 and the step S120 of forming the module connector 115 may be performed using a roll-to-roll type slot die coating method, but may be performed using any of various other coating methods, such as spray coating, spin coating, or gravure coating. The step S110 of forming the module main body 110 may include the step S120 of forming the module connector 115.

The step S130 of forming the terminal molding unit 120 refers to the step of forming the wiring terminal 122 between the first electrode layer 112 formed on one end of the module main body 110 and the second electrode layer 113 formed on the other end of the module main body 110 using an insulating plastic so as to be electrically molded and connected to a power supply. The step of forming the terminal molding unit 120 includes a step S131 of placing the wiring terminal 122 and a step S132 of molding the molding portion 123.

The step S131 of placing the wiring terminal 122 reers to the step of connecting the wires 121a and 121b to the first electrode layer 112 and the second electrode layer 113 respectively and forming the wiring terminal 122 on the end of each wire 121a or 121b. The step S132 of molding the molding portion 123 refers to the step of integrally molding the molding portion 123 with the module main body 110 so as to surround the end of the module main body 110, the wires 121a and 121b, and a portion of the wiring terminal 122.

The step S140 of sealing the module is performed using a process of shielding the module from external environmental factors including oxygen and moisture, and refers to the step of sealing both the module main body 110 including the module connector 115 and the terminal molding unit 120 via a laminating process using a transparent barrier film, which is formed of, for example, PET, so as to complete the organic solar cell module.

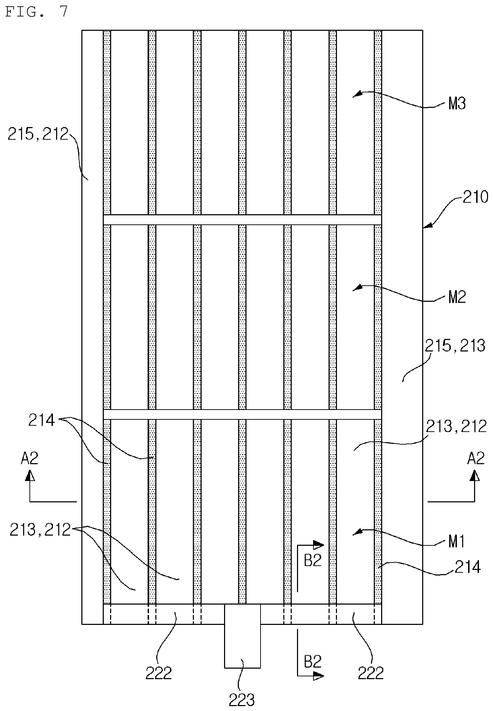

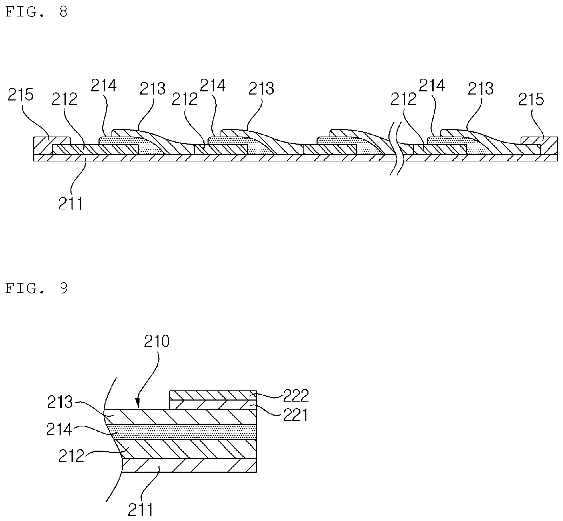

FIG. 7 is a plan view schematically illustrating an organic solar cell module according to a second embodiment of the present invention, FIG. 8 is a cross-sectional view taken along the arrows A2-A2 of FIG. 7, and FIG. 9 is a cross-sectional view taken along the arrows B2-B2 of FIG. 7. As illustrated, the organic solar cell module according to the second embodiment of the present invention is configured such that a module main body 210 is provided with an insulating portion 221, an electrode connecting portion 222, and a wiring terminal 223. In the second embodiment, the module main body 210 has a structure in which three unit modules M1, M2 and M3 are integrally arranged on a single substrate 211.

The configurations of the module main body 210, the substrate 211, a first electrode layer 212, a second electrode layer 213, an optical active layer 214, and a module connector 215 are respectively the same as the configurations of the module main body 110, the substrate 111, the first electrode layer 112, the second electrode layer 113, the optical active layer 114, and the module connector 115 of the first embodiment, and thus a detailed description thereof will be omitted.

The insulating portion 221 is formed between the first electrode layer 212, which is formed on one end of the module main body 210, and the second electrode layer 213, which is formed on the other end of the module main body 210, so as to insulate a conductive portion. The insulating portion 221 may be formed using a transparent insulating material such as, for example, polyethylene terephthalate (PET). The insulating portion 221 may be coated with any one of various insulating materials and any of various coating methods.

The electrode connecting portion 222 is formed on the insulating portion 221 and connects the first electrode layer 212 and the second electrode layer 213 to each other. The electrode connecting portion 222 is formed as a silver (Ag) electrode via printing using Ag paste, in the same manner as the module connector 215.

The wiring terminal 223 is formed on the middle portion of the electrode connecting portion 222 and is connected to a power supply. The wiring terminal 223 may be a wiring terminal of a charging unit for connection with a power supply of a charger, or may be a wiring terminal of a USB charging unit for connection with a USB. Thus, the organic solar cell module of the present invention may be used to charge various electronic appliances because a USB connector is integrally connected to the electrode thereof, or may be used to charge various electronic appliances that are chargeable via a USB owing to a female-type USB charging unit formed therein.

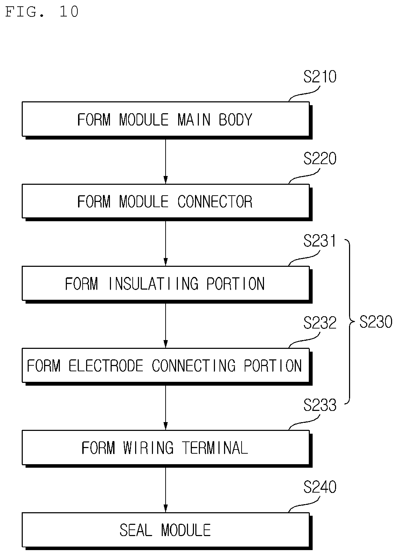

FIG. 10 is a flowchart illustrating a method of manufacturing the organic solar cell module according to the second embodiment of the present invention illustrated in FIG. 7. As illustrated, the method of manufacturing the organic solar cell module according to the second embodiment includes a step S210 of forming a module main body, a step S220 of forming a module connector, a step S230 of forming a terminal unit, and a step S240 of sealing the module. The step S10 of forming the module main body, the step S220 of forming the module connector, and the step S240 of sealing the module are the same as the step S110 of forming the module main body, the step S120 of forming the module connector, and the step S140 of sealing the module according to the first embodiment, and thus, a detailed description thereof will be omitted.

The step S230 of forming the terminal unit includes a step S231 of forming an insulating portion, a step S232 of forming an electrode connecting portion, and a step S233 of forming a wiring terminal.

The step S231 of forming the insulating portion 221 refers to the step of forming a conductive portion between the first electrode layer 212, which is formed on one end of the module main body 210, and the second electrode layer 213, which is formed on the other end of the module main body 210. The step 231 may be the step of coating the conductive portion using an insulating material (e.g. PET) and any of various coating methods.

The step S232 of forming the electrode connecting portion 222 refers to the step of forming respective electrode connecting portions 222, which connect the first electrode layer 212 and the second electrode layer 213 to each other, on the insulating portion 221. The electrode connecting portions 222 are coated with the same material as the module connector 215 via any of various coating methods. The step S233 of forming the wiring terminal 223 refers to the step of integrally forming the wiring terminal 223 on the end of each electrode connecting portion 222. The step S233 may be performed at the same time as the step S232 of forming the electrode connecting portion 222.

As is apparent from the above description, with an organic solar cell module and a method of manufacturing the same according to the present invention, it is possible to easily form a wiring terminal for connection with a power supply, and also possible to easily charge batteries of various electronic appliances as well as electronic appliances that are chargeable via an USB by integrating a charging unit or a USB charging unit in the organic solar cell module.

In addition, as a result of integrating the charging unit or the USB charging unit in the organic solar cell module, it is possible to minimize the number of processes of connecting the wiring terminal, to achieve increased durability, and to facilitate the easy charging of various electronic appliances.

Although the embodiments of the present invention, which are disclosed in this specification and the drawings, are provided to easily describe the technical description of the present invention and propose specific examples to assist the understanding of the present invention, and are not intended to limit the scope of the present invention. It will be clear to those skilled in the art that, in addition to the embodiments disclosed herein, various other modifications based on the technical sprit of the present invention are possible.

### [Description of Reference Numerals]

110, 210: module main body
111, 211: substrate
112, 212: first electrode layer
113, 213: second electrode layer
114, 214: optical active layer
115, 215: module connector
120: terminal molding unit
121a, 121b: wire
122, 223: wiring terminal
123: molding portion
221: insulating portion
222: electrode connecting portion
M1, M2, M3: unit module

## Claims

1. An organic solar cell module comprising:
a module main body having a plurality of rows of a first electrode layer and a plurality of rows of a second electrode layer formed on the first electrode layer with an optical active layer interposed therebetween; and
a terminal molding unit having a wiring terminal, which is integrally molded between the first electrode layer formed on one end of the module main body and the second electrode layer formed on a remaining end of the module main body, the wiring terminal being connected to a power supply.

2. The organic solar cell module according to claim 1, wherein the terminal molding unit includes:
wires connected respectively to the first electrode layer and the second electrode layer;
the wiring terminal integrally formed on an end of each wire so as to be connected to the power supply; and
a molding portion integrally molded with the module main body so as to surround an end of the module main body, the wires, and a portion of the wiring terminal.

3. The organic solar cell module according to claim 1, wherein the module main body includes a plurality of unit modules arranged thereon, and
wherein the first electrode layer formed on the one end of the module main body and the second electrode layer formed on the remaining end of the module main body are coated with a module connector, which electrically interconnects the unit modules so as to connect the unit modules to the wire.

4. The organic solar cell module according to claim 3, wherein the module connector is formed as a silver (Ag) electrode via printing.

5. An organic solar cell module comprising:
a module main body having a plurality of rows of a first electrode layer and a plurality of rows of a second electrode layer formed on the first electrode layer with an optical active layer interposed therebetween;
an insulating portion formed between the first electrode layer formed on one end of the module main body and the second electrode layer formed on a remaining end of the module main body so as to insulate a conductive portion;
an electrode connecting portion formed on the insulating portion to connect the first electrode layer and the second electrode layer to each other; and
a wiring terminal formed on a middle portion of the electrode connecting portion and connected to a power supply.

6. The organic solar cell module according to claim 5, wherein the module main body includes a plurality of unit modules arranged thereon, and
wherein the first electrode layer formed on the one end of the module main body and the second electrode layer formed on the remaining end of the module main body are coated with a module connector, which electrically interconnects the unit modules so as to connect the unit modules to the electrode connecting portion.

7. The organic solar cell module according to claim 6, wherein the module connector or the electrode connecting portion is formed as a silver (Ag) electrode via printing.

8. The organic solar cell module according to claim 1 or 5, wherein the wiring terminal is a wiring terminal of a charging unit for connection with a power supply of a charger.

9. The organic solar cell module according to claim 1 or 5, wherein the wiring terminal is a wiring terminal of a universal serial bus (USB) charging unit for connection with a USB.

10. A method of manufacturing an organic solar cell module, the method comprising:
forming a module main body having a plurality of rows of a first electrode layer and a plurality of rows of a second electrode layer formed on the first electrode layer with an optical active layer interposed therebetween; and
forming a terminal molding unit having a wiring terminal, which is integrally molded between the first electrode layer formed on one end of the module main body and the second electrode layer formed on a remaining end of the module main body, the wiring terminal being connected to a power supply.

11. The method according to claim 10, wherein the forming the terminal molding unit includes:
connecting wires respectively to the first electrode layer and the second electrode layer and integrally forming the wiring terminal on an end of each wire; and
integrally molding a molding portion with the module main body so as to surround an end of the module main body, the wires, and a portion of the wiring terminal.

12. A method of manufacturing an organic solar cell module, the method comprising:
forming a module main body having a plurality of rows of a first electrode layer and a plurality of rows of a second electrode layer formed on the first electrode layer with an optical active layer interposed therebetween;
forming an insulating portion configured to insulate a conductive portion between the first electrode layer formed on one end of the module main body and the second electrode layer formed on a remaining end of the module main body; and
forming respective electrode connecting portions on the insulating portion to connect the first electrode layer and the second electrode layer to each other and integrally forming a wiring terminal on an end of each electrode connecting portion.
